**Europäisches Patentamt**

**European Patent Office**

**Office européen des brevets**

(19)

(11) Numéro de publication: **0 088 030**

**B1**

(12)

# FASCICULE DE BREVET EUROPEEN

(45) Date de publication du fascicule du brevet: **20.07.88**

(51) Int. Cl.⁴: **H 03 K 17/975**

(21) Numéro de dépôt: **83400433.5**

(22) Date de dépôt: **03.03.83**

(54) **Perfectionnements aux claviers capacitifs.**

(30) Priorité: **03.03.82 FR 8203545**

(43) Date de publication de la demande:
**07.09.83 Bulletin 83/36**

(45) Mention de la délivrance du brevet:
**20.07.88 Bulletin 88/29**

(84) Etats contractants désignés:
**DE FR IT**

(56) Documents cités:
**DE-A-2 746 655**
**FR-A-2 055 758**
**FR-A-2 475 760**

(73) Titulaire: **Lewiner, Jacques**
**5, rue Bory d'Arnex**
**F-92210 Saint-Cloud (FR)**

(73) Titulaire: **Hennion, Claude**
**18, rue Flatters**
**F-75005 Paris (FR)**

(72) Inventeur: **Lewiner, Jacques**
**5, rue Bory d'Arnex**
**F-92210 Saint-Cloud (FR)**
Inventeur: **Hennion, Claude**
**18, rue Flatters**
**F-75005 Paris (FR)**

(74) Mandataire: **Behaghel, Pierre et al**
**CABINET PLASSERAUD 84 rue d'Amsterdam**
**F-75009 Paris (FR)**

Courier Press, Leamington Spa, England.

EP 0 088 030 B1

## Description

L'invention est relative aux claviers capacitifs de type matriciel, c'est-à-dire aux circuits électriques destinés à assurer une pluralité de commandes distinctes à partir des appuis de touches composant un clavier, ces circuits comportant un arrangement matriciel de plots associés chacun à l'une des touches du clavier et présentant la même répartition en lignes et en colonnes que ces touches, chacun desdits plots étant lui-même composé de deux plages conductrices isolées électriquement l'une de l'autre et susceptibles d'être couplées capacitivement l'une à l'autre par simple actionnement de la touche associée, cet actionnement ayant pour effet de rapprocher simultanément de ces deux plages une même armature conductrice mobile, également associée à ladite touche.

Les applications de ces claviers sont multiples: ils permettent d'introduire dans des appareils de calcul et de commande appropriés les données associées aux différentes touches, lesquelles données peuvent être de toutes natures désirables et par exemple des chiffres ou lettres à reproduire, des opérations à effectuer.

Dans ces claviers, les plages sont regroupées électriquement selon les lignes et colonnes de la matrice de façon telle que l'actionnement de la touche correspondant à la ligne de rang $i$ et à la colonne de rang $j$ du clavier ait pour effet par exemple de connecter électriquement l'entréé de rang $i$ du clavier à sa sortie de rang $j$.

A cet effet toutes les plages d'un même type, par exemple celles de guache, sont connectées entre elles par lignes, chaque conducteur de connexion relatif à une ligne étant lui-même relié à une entrée du clavier et toutes les plages de l'autre type (ici de droite) sont connectées entre elles par colonnes, chaque conducteur de connexion relatif à une colonne étant relié à une sortie du clavier.

Le circuit électronique d'exploitation d'un tel clavier comprend des moyens d'émission de signaux électriques successivement sur les diversess entrées ci-dessus décrites et des moyens de détection de tels signaux aux dites sorties. Lorsque les touches ne sont pas activées, l'énergie électrique recueillie au niveau des sorties lors de l'émission de tels signaux est faible et due uniquement aux couplages capacitifs parasites. Au contraire, lorsqu'une touche est enfoncée, un fort couplage capacitif est réalisé entre la ligne et la colonne correspondant à la dite touche enfoncée, ce que se traduit par une forte augmentation de l'énergie électrique transmise vers la sortie correspondante.

Les différents conducteurs correspondant aux lignes et colonnes se croisent en de nombreux points. Or ils doivent être isolés électriquement les uns des autres.

Pour assurer un tel isolement, on rapporte en général les deux réseaux de conducteurs correspondant respectivement aux lignes et aux colonnes sur respectivement les deux faces opposés d'un support isolant, telle qu'un circuit imprimé, sur l'une seulement des deux faces duquel sont rapportées toutes les plages conductrices.

Cette formule exige le perçage de multiples trous dans ledit support afin de relier électriquement aux plages correspondantes les conducteurs qui ne sont pas rapportés sur la même face que ces plages.

Selon une formule améliorée qui a été exposée dans le brevet des Etats-Unis d'Amérique No. 3 921 167, les conducteurs de chaque réseau, ainsi que les plages connectées à ces conducteurs, sont rapportés sur une même face d'une plaque isolante, les plaques correspondnat aux deux réseaux étant distinctes, et les deux plaques ainsi revêtues sont juxtaposées d'une contre l'autre, avec leurs conducteurs orientés l'une vers l'autre, mais avec interposition d'une feuille isolante intercalaire.

Dans ce cas, le couplage capacitif entre les deux plages associées à une même touche n'est pas réalisé uniquement à travers l'armature conductrice, mais aussi à travers la feuille isolante intercalaire et deux fois à travers la plaque isolante située du côté de ladite armature.

Cette formule permet certes d'éviter le perçage de trous de connexion multiples dans un support isolant. Mais dans ce brevet, le couplage capacitif est fait à travers trois épaisseurs de plaques et de feuille isolantes de faibles permittivité. Par "permittivité" on entend ici et partout dans le présent texte la permittivité "relative", c'est-à-dire la valeur de cette quantité (appelée aussi parfois "constante diélectrique" ou "pouvoir inducteur spécifique") exprimée par rapport à celle du vide.

Selon une autre formule améliorée qui a été exposée dans le brevet Grande-Bretagne No. 1 582 640, les conducteurs de chaque réseau, ainsi que les plages conectées à ces conducteurs sont rapportés sur les deux faces d'une feuille isolante, du type de celles utilisées pour faire de circuits imprimés qui ont des épaisseurs supérieures à 1 mm et des permittivités de l'ordre de 2.

Dans ces deux formules améliorées, les plages conductrices sont placées respectivement contre les deux faces opposées de la même feuille isolante, et ce en des positions telles que la projection de l'une quelconque de ces plages conductrices dans le plan de l'autre plage, selon la direction perpendiculaire à ce plan, se trouve à côté de cette autre plage, à une petite distance de celle-ci.

Ces deux formules améliorées présentent le grave inconvénient d'assurer le couplage capacitif à travers une ou plusieurs capacités en série de valeurs faibles, typiquement inférieure à 5 pF, ce qui a pour effet de produire une très faible variation du couplage entre les lignes et les colonnes lorsque les touches sont enfoncées.

L'exploitation de telles faibles variations est difficile et exige de recourir à des circuits de détection sensibles, et éventuellement à des circuits de compensation. Un autre inconvénient de la faible variation de couplage, et donc de la grande sensibilité de l'électronique de détection requise, est d'entraîner une forte sensiblité aux parasites électromagnétiques.

Les inventeurs ont constaté que tous ces inconvénients sont écartés quand la feuille isolante est réalisée en l'un au moins des polymères et copolymères d'un matériau du groupe constitué des mono-, di- et trifluorooléfines de la famille de l'éthylène avec une épaisseur relativement faible, savoir au plus égale à 50 microns.

Les matériaux en question sont le polyfluorure de vinyle ($-CHF-CH_2-$), le polyfluorure de vinylidène ($-CH_2-CF_2-$) et le polytrifluoroéthylène ($-CHF-CF_2-$). Ces matériaux ont des permittivités de l'ordre de 10 et même davantage, en particulier après étirage mécanique et/ou polarisation électrique sous champ électrique élevé, de l'ordre de 10 kV/cm ou davantage.

Il résulte de la forte permittivité et de la grande minceur de la feuille isolante que la capacité du condensateur formé entre l'armature conductrice mobile en sa position assurant le couplage capacitif maximum et la plage la plus éloignée de cette armature est relativement élevée: si l'on considère que la surface de chaque plage est généralement de l'ordre de 0,5 cm², la capacité du condensateur en question, dont le diélectrique est constitué par la feuille isolante considérée, est en général supérieure à 50 pF et notamment de l'ordre de 100 pF.

Dans ces conditions, la capacité globale du couplage capacitif assuré entre deux plages associées d'un même plot est:—

pratiquement nulle, typiquement inférieure à 2 pF lorsque la touche correspondante n'est pas actionnée et que l'armature conductrice demeure donc écartée des deux plages,

et, au contraire, très élevée lorsque cette armature est placée en sa position de couplage, ladite capacité globale correspondant alors à l'ensemble en série de la capacité relativement élevée qui vient d'être analysée et de celle, encore plus élevée, formée entre l'armature et celle, des deux plages, qui est la plus proche de cette armature.

Dans des modes de réalisation préférés, on a recours en outre à l'une et/ou à l'autre des dispositions suivantes:

la feuille isolante est en polyfluorure de vinylidène ou un de ses copolymères,

la feuille isolante selon l'alinéa précédent a subi un étirage méchanique et/ou une polarisation électrique sous champ électrique élevé,

les plages conductrices sont rapportées sur les deux faces de la feuille isolante,

l'armature conductrice mobile est, selon l'alinéa précédent, revêtue sur sa face orientée vers les plages conductrices d'une mince pellicule isolante,

l'armature, selon l'alinéa précédent, est constituée en aluminium et est revêtue sur sa face orientée vers les plages conductrices d'une mince pellicule d'oxyde d'aluminium,

la pellicule isolante, selon l'alinéa qui précède le précédent, est constituée en un polymère de permittivité élevée, notamment une pellicule en polyfluorure de vinylidène de faible épaiseur, l'armature conductrice pouvant alors être constituée par une métallisation de la face, de cette pellicule, la plus éloignée des plages conductrices,

les plages conductrices sont rapportées sur des plaques isolantes placées de part et d'autre de la feuille isolante, sur les faces, de ces plaques, adjacentes à la feuille isolante,

la plaque isolante, selon l'alinéa précédent, située du côté de l'armature conductrice, est constituée en un polymère der permittivité élevée, notamment une feuille en polyfluorure de vinylidène de faible épaisseur, les plages conductrices pouvant alors être constituées par métallisation de la face, de cette plaque, située du côté de la feuille isolante.

L'invention comprend, mises à par ces dispositions principales, certaines autres dispositions qui s'utilisent de préférence en même temps et dont il sera plus explicitement question ci-après.

Dans ce qui suit l'on va décrire des modes de réalisation préférés de l'invention en se référant au dessin ci-annexé d'une manière bien entendu non limitative.

La figure 1, de ce dessin, montre un clavier capacitif conforme à l'invention selon une coupe schématique exécutée au niveau de l'une de ses touches.

La figure 2 montre en vue perspective la feuille isolante selon l'invention inclue dans un tel clavier, fueille contre les deux faces de laquelle sont appliqués les circuits électriques.

La figure 3 montre partiellement en plan une variante de ladite feuille.

La figure 4 montre en vue perspective partielle encore une autre variante de ladite feuille.

Le clavier capacitif comprend un arrangement matriciel—c'est-à-dire réparti en lignes et colonnes—de touches schématisées par la référence 1, chaque touche comprenant une armature conductrice plate 2 et des moyens élastiques, non représentés propres à solliciter cette armature selon la flèche F, perpendiculairement à cette armature, vers une position de repos.

A chaque touche est associée un plot conducteur 3 composé de deux plages conductrices minces $3_1$ et $3_2$ isolées électriquement l'une de l'autre et susceptibles d'être couplées capacitivement l'une à l'autre uniquement lorsque l'armature 2 est rapprochée d'elles selon la flèche G opposée à la flèche F, c'est-à-dire à l'encontre de l'effort de rappel des moyens élastiques ci-dessus.

Les deux plages $3_1$ et $3_2$ sont, selon l'invention, au contact respectivement des deux faces opposées d'une même feuille isolante 4, et ce en des positions telles que la projection de l'une quelconque de ces plages dans la plan de l'autre plage, selon la direction perpendiculaire à ce plan, se trouve à côté de cette autre plage, à une petite distance de celle-ci.

La feuille isolante 4 est, selon l'invention, réalisée en l'un, au moins, des polymères et copolymères d'une substance choisie dans le groupe constitué par les mono-, di- et trifluorooléfines de la famille de l'éthylène.

Chacune des plages conductrices $3_1$ et $3_2$ considérées ici présente toute forme désirable, par exemple celle d'un rectangle, ou encore celle d'un demi-cercle comme illustré sur le dessin: dans ce dernier cas, les diamètres délimitant ces demi-cercles sont orientés parallèlement l'un à l'autre et disposés à proximité l'un de l'autre, ces diamètres et leurs projections respectives sur les faces opposées de la feuille isolante 4 délimitant une étroite bande 5 de matière isolante interposée entre les deux plages.

Ces plages conductrices sont rapportées ou imprimées de toute manière désirable à raison d'une plage $3_1$ et d'une plage $3_2$ en regard de chaque touche 1, toutes les plages au contact d'une même face de la feuille 4 étant disposées côte à côte contre cette face, parallèlement les unes aux autres, selon le même arrangement matriciel que les touches du clavier.

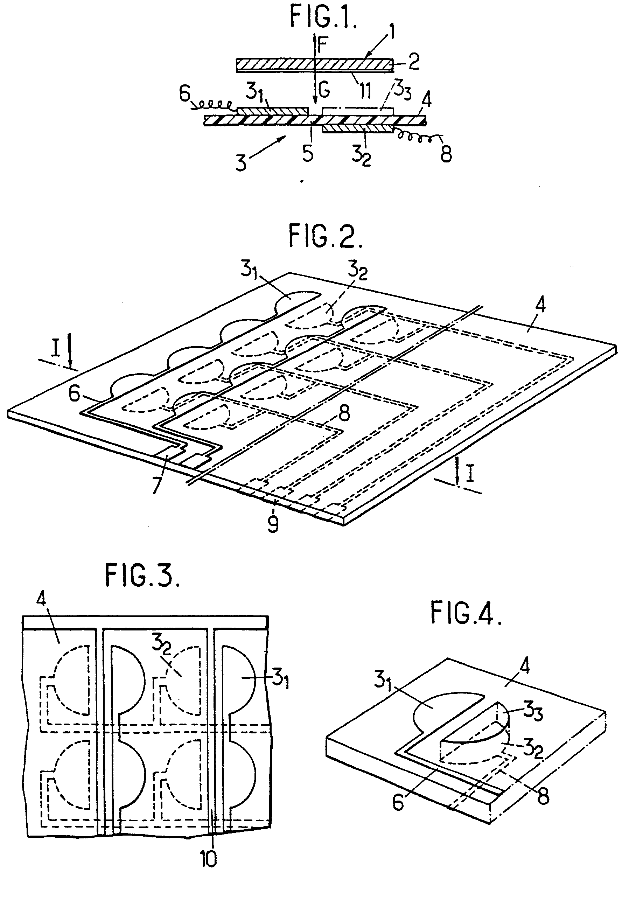

Toutes les plages conductrices du type de la plage $3_1$, savoir cells qui sont au contact "à gauche" de la face "supérieure" de la feuille isolante 4 dans la case des figures 1 et 2, sont connectées électriquement entre elles selon des rangées parallèles entre elles, savoir selon des "colonnes" si l'on considère la figure 2 depuis son extrémité inférieure gauche. Ces connexions sont aussurées à l'aide de conducteurs 6 eux-mêmes en contact en même temps que les plages $3_1$ de la face supérieure considérée de la feuille 4 et chacun de ces conducteurs 6 est lui-même raccordé, sur un bord de cette feuille, ou de la plaque isolante, à une borne de connexion extérieure 7.

De même, toutes les plages conductrices du type de la plage $3_2$, savoir les plages qui sont au contact "à droite" de la face "inférieure" de la feuille 4 dans l'exemple ci-dessus adopté, sont connectées entre elles selon des "lignes" parallèles entre elles par des conducteurs électriques 8 eux-mêmes raccordés à des bornes de connexion latérale 9.

Les largeurs des conducteurs de connexion 6 et 8 sont faibles de façon à minimiser les capacités parasites susceptibles de se former à travers la feuille aux zones de "croisement" desdits conducteurs.

Vu sa grande minceur, la feuille isolante 4 est relativement flexible: on la renforce avantageusement en l'appliquant contre un plaque rigide isolante de support de toute nature désirable. Cette plaque rigide peut être constituée en un matériau beaucoup plus économique que celles en résine époxy généralement utilisées lorsque les différentes, plages de chaque plot sont disposées sur une seule face d'une telle plaque, solution pour laquelle l'une des plages de chacun de ces plots doit être réunie à son conducteur de raccordement extérieure par un trou traversant ladite plaque, ainsi qu'exposé ci-dessus.

Cette plaque rigide peut également constituer l'une desdites plaques isolantes.

Pour renforcer la séparation électrique des deux plages conductrices $3_1$ et $3_2$ de chaque plot, on dispose avantageusement le long des bandes isolantes 5 qui les séparent, contre au moins l'une des deux faces de la feuille isolante 4, des fils conducteurs 10 (figure 3) mis à la masse.

Pour éviter tout risque de contact entre ces fils 10 et l'armature mobile 2, lorsqu'aucune couche isolante n'est prévue sur la face, de cette armature, orientée vers les plages, il suffit de disposer les fils 10 au contact de la face, de la feuille 4, la plus éloignée de cette armature 2. Lorsque les plages conductrices au contact de la face de la feuille placée en regard de l'armature mobile sont directement rapportées sur cette feuille, et pour éviter les inconvénients d'un appui hésitant ou mal centré sur l'armature 2, appui qui pourrait se traduire par un mauvais contact entre celle-ci et une portion de la surface en regard du plot, il est avantageux de rapporter contre la face, de la feuille 4, la plus proche de l'armature, à côté de chaque première plage $3_1$ déjà rapportée sur cette face, une troisième plage conductrice $3_3$ (figure 4) ayant les mêmes dimensions et la même orientation que la seconde plage $3_2$ et étant disposée à l'emplacement de la projection de cette seconde plage selon la flèche F sur la face considérée.

Une telle construction évite la présence de couches d'air inopportunes entre l'armature mobile 2 et les surfaces contre lesquelles elle est appliquée lors de l'appui de la touche correspondante, et la capacité globale du couplage alors assuré entre les deux plages $3_1$ et $3_2$ lors d'un tel appui est ainsi toujours maximum.

Le fonctionnement des claviers décrits ci-dessus est le suivant.

L'enfoncement de chaque touche 1 d'un tel clavier selon la flèche G (figure 1) doit avoir pour effet de relier capacitivement entre elles les deux plages $3_1$ et $3_2$, et donc les conducteurs 6 et 8 correspondants, lesquels sont eux-mêmes connectés respectivement à une source de signal électrique et à un dispositif d'exploitation de ce signal.

Cette liaison électrique entre les deux plages $3_1$ et $3_2$ est assurée par couplage capacitif de chacune de ces deux plages avec l'armature conductrice 2.

Le couplage entre cette armature 2 et la première plage $3_1$ la plus proche de cette armature peut être assuré par contact mutuel direct entre ces deux éléments conducteurs, lorsque les plages conductrices au contact de la face de la feuille isolante 4 placée en regard de l'armature mobile sont directement rapportées sur cette feuille, ce qui correspond à une capacité de couplage infinie.

Mais si l'on désire éviter un tel contact mutuel direct, lequel peut être une source de désordres dans certains cas, il suffit de prévoir sur l'un des deux éléments conducteurs considérés, de préférence sur l'armature 2, une mince pellicule isolante 11.

A cet effet par exemple, si l'armature 2 est constituée en aluminium, la pellicule 11 peut être constituée par une couche superficielle d'alumine dont l'épaisseur est inférieure au micron: la capacité de couplage électrique réalisé à travers une telle couche est encore très élevée.

Il convient de souligner que la pellicule isolante 11 ci-dessus, du fait qu'elle est rapportée sur un élément conducteur de support, peut être extrêment mince, par exemple inférieure à 5 microns ou moins, et en particulier beaucoup plus mince qu'une feuille cohérente indépendante destinée elle-même à servir de support à des circuits imprimés.

La pellicule isolante 11 en question peut également être constitué par une feuille en un matériau polymérique de permittivité élevée, de préférence de l'ordre ou supérieure à 10.

Cette feuille 11 peut présenter elle-même une très faible épaisseur, vu qu'elle n'est pas destinée à supporter des circuits imprimés: il s'agit par exemple d'une feuille de polyfluorure de vinylidène épaisse de 10 microns.

Dans ce dernier cas, l'armature conductrice peut être constituée par une métallisation de la face, de la feuille 11, la plus éloignée des plages conductrices.

Lorsque les plages conductrices, au contact de la face de la feuille isolante 4, placées en regard de l'armature mobile sont rapportées sur un plaque isolante, cette plaque évite le contact direct entre l'armature mobile et la plague conductrice $3_1$. Cette plaque isolante est de préférence d'épaisseur inférieure à 50 microns et constituée en un matériau de permittivité de l'ordre de 10 ou davantage. Il s'agit de préférence d'une feuille de polyfluorure de vinylidène. Cett feuille joue alors le rôle de la pellicule isolante 11 ci-dessus décrite.

Le couplage réalisé entre l'armature mobile 2 et la seconde plage $3_2$, la plus éloignée de cette armature, se fait à travers la feuille isolante 4 et éventuellement à travers la très mince pellicule isolante 11, s'il en est prévu une.

La capcité de ce couplage est encore relativement élevée en raison des caractéristiques particulières, mentionnées ci-dessus, de la feuille isolante 4: si en effet la permittivité de cette feuille est de l'ordre de 10 et son épaisseur, de l'ordre de 50 microns, et si la surface de la plage conductrice $3_1$ est de l'ordre de 0,5 cm$^2$, la capacité en question est de l'ordre de 100 pF.

Par suite, la capacité globale résultant du couplage réalisé entre les deux plages conductrices $3_1$ et $3_2$, constituée par les deux capacités ci-dessus décrites montées en série, est elle-même très élevée: elle est ici supérieure à 20 pF et même en général à 50 pF, alors qu'elle n'atteint généralement pas 10 pF avec les formules améliorées évoquées ci-dessus.

Il est à noter que la mince pellicule isolante 11 peut être localisée uniquement en regard des premières plages $3_1$ et être supprimée en regard des secondes plages $3_2$—et éventuellement des troisièmes plages $3_3$—, une compensation d'épaisseur pouvant éventuellement être prévue de façon à éviter tout contact en biais lors de l'appui sur la touche correspondante: une telle formule permet encore d'accroître la capacité du couplage entre l'armature mobile 2 et la seconde plage $3_2$.

Il est à noter également que la pellicule isolante 11 peut être rendue inutile si l'armature 2 est rendue électriquement "flottante", c'est-à-dire elle-même isolée de toute connexion électrique extérieure permanente: on peut remarquer en effet que, dans une telle hypothèse, même lorsque cette armature 2 se trouve en sa position pour laquelle elle assure le couplage capacitif, aucun contact direct n'est établi entre cette armature 2 et la plage $3_2$ et que par conséquent le simple contact direct entre cette armature et la plage $3_1$ ne ferme directement aucun circuit électrique.

Dans une telle hypothèse, il convient de prévoir une pellicule isolante sur la face, de l'armature mobile 2, qui est opposée à sa face conductrice alors orientée vers les plages, en particulier lorsque le déplacement de cette armature mobile 2 est commandé par appui direct d'un doigt sur celle-ci, et ce notamment de façon à éviter de mettre à la masse à travers le corps de l'utilisateur cette armature et le tronçon de circuit éventuellement mis en contact direct avec elle à travers la première plage $3_1$.

Dans ce dernier cas, il peut être avantageux de constituer l'armature mobile en question par métallisation d'une feuille isolante, la couche métallisée constituant alors ladite armature et étant orientée en direction des plages.

On peut également constituer l'armature conductrice elle-même par la peau d'un doigt venant s'appliquer contre un plot, cette peau venant alors en contact direct avec la plage $3_1$ constitutive de ce plot, à moins que soit prévue une feuille intercalaire isolante der permittivité élevée et de faible épaisseur, laquelle feuille peut être commune à tous les plots et peut servir alors de protection générale au clavier.

Cette feuille peut également être constituée par la plaque isolante, porteur des plages conductrices, elle-même.

En raison du petit nombre et de la petite épaisseur de ses couches constitutives, le clavier ci-dessus est particulièrement bien adapté aux réalisations entièrement transparentes. Les feuilles transparentes de polymères réalisées à partir d'une substance choisie dans le groupe constitué par les mono-, di- et trifluorooléfines de la famille de l'éthylène peuvent être utilisées pour constituer la feuille et les plaques isolantes.

Dans ce cas, les diverses électrodes et conducteurs décrits ci-dessus sont réalisés par dépôt sous vide ou chimique de couches minces de films conducteurs et transparents tels que l'oxyde d'indium et d'étain (I.T.O.) sur la feuille et les plaques isolantes. Ces procédés peuvent échauffer les substrats sur lesquels ces dépôts sont effectués; pour cette raison, le polyfluorure de vinylidène présente un grand intérêt car il possède une stabilité exceptionnelle à haute température.

En suite de quoi, et quel que soit le mode de réalisation adopté, on disposé finalement d'un clavier cpaacitif dont la construction et le fonctionnement résultent suffisamment de ce qui précède.

Ce clavier présente, par rapport à ceux antérieurement connus, un certain nombre d'avantages et en particulier celui d'une grande simplicité de fabrication, d'un prix de revient très bas, et en même temps d'une grande capacité des couplages réalisés, d'une simplification extrême de l'électronique d'exploitation et enfin d'une grande insensibilité aux parasites électriques ou magnétiques.

Comme il va de soi, et comme il résulte d'ailleurs déjà de ce qui précède, l'invention ne se limite nullement à ceux de ses modes d'application et de réalisation qui ont été plus spécialement envisagés; elle en embrasse, au contraire, toutes les variantes.

## Revendications

1. Clavier capacitif de type matriciel, destiné à assurer une pluralité de commandes distinctes à partir des appuis de touches (1) d'un clavier et comportant un arrangement matriciel de plots (3) associés chacun à l'une des touches du clavier, ces plots présentant la même répartition en lignes et en colonnes que ces touches, chacun desdits plots étant lui-même composé de deux plages conductrices ($3_1$, $3_2$) isolées électriquement l'une de l'autre et susceptibles d'être couplées capacitivement l'une à l'autre par simple actionnement de la touche associée, cet actionnement ayant pour effet de rapprocher simultanément de ces deux plages une même armature conductrice (2) également associée à ladite touche, les deux plages ($3_1$, $3_2$) étant respectivement placées contre les deux faces opposées d'une feuille isolante (4), en des positions telles que la projection de l'une quelconque de ces plages dans le plan de l'autre plage, selon la direction perpendiculaire à ce plan, se trouve à côté de cette autre plage, à une petite distance de celle-ci, caractérisé en ce que cette feuille isolante (4) est constituée en l'un au moins des polymère et copolymères d'une substance choisie parmi le groupe constitué des mono-, di- et trifluorooléfines de la famille de l'éthylène, l'épaisseur de ladite feuille isolante étant au plus égale à 50 microns.

2. Clavier capacitif selon la revendication 1, caractérisé en ce que la feuille isolante est constituée en polyfluorure de vinylidène.

3. Clavier capacitif selon la revendication 1 ou 2, caractérisé en ce que la feuille isolante a été formée par étirage.

4. Clavier capacitif selon la revendication 1, 2 ou 3, caractérisé en ce que la feuille isolante a été polarisée électriquement par action d'un champ électrique.

5. Clavier capacitif selon l'une quelconque des revendications précédentes, caractérisé en ce que les plages ($3_1$, $3_2$) sont rapportées sur la feuille isolante.

6. Clavier capacitif selon la revendication 5, caractérisé en ce que l'armature conductrice (2) est revêtue, sur sa face orientée vers les plages conductrices d'une mince pellicule isolante (11) constituée en un matériau de la même famille que celle de la feuille isolante (4).

7. Clavier capacitif selon la revendication 1, caractérisé en ce que les plages ($3_1$, $3_2$) sont portées par au moins l'une de deux plaques isolantes, sur la face de cette ou de ces plaques, orientée vers la feuille isolante (4).

8. Clavier capacitif selon la revendication 7, caractérisé en ce que la plaque isolante située du côté de l'armature mobile est constituée en un matériau de la même famille que celle de la feuille isolante (4).

9. Clavier capacitif selon l'une quelconque des précédentes, revendications, caractérisé en ce que ses divers constituants sont transparents optiquement.

## Patentansprüche

1. Kapazitives Tastenfeld der Matrizenart, das dazu bestimmt ist, eine Mehrzahl von unterschiedlichen Befehlen über Tastenauflager (1) eines Tastenfelds auszuführen und das eine Matrixanordnung von Kontakten (3) aufweist, die jeweils einer der Tasten des Tastenfeldes zugeordnet sind, wobei die Kontakte die gleiche Aufteilung in Zeilen und Spalten wie die Tasten haben, und jeder Kontakt seinerseits aus zwei leitenden Bereichen ($3_1$, $3_2$) besteht, die gegeneinander elektrisch isoliert sind und die kapazitiv miteinander durch einfache Betätigung der zugeordneten Taste gekoppelt werden können, wobei die Betätigung bewirkt, daß gleichzeitig diese beiden Bereiche sich einem gemeinsamen leitenden Anker (2) annähern, der ebenfalls der Taste zugeordnet ist, wobei die beiden Bereich ($3_1$, $3_2$) jeweils gegen die beiden gegenüberliegenden Flächen einer isolierenden Folie (4) an solchen Stellen angelegt sind, daß sich die Projektion eines der Bereiche in der Ebene des anderen Kontaktes in eine Richtung senkrecht zu dieser Ebene sich neben diesem anderen Bereich in einem kleinen Abstand von demselben befindet, dadurch gekennzeichnet, daß die isolierende Folie (4) wenigstens aus Polymeren und Copolymeren einer Substanz besteht, die aus der Gruppe gewählt ist, die Mono-, Di- und Trifluorolefine der Familie von Ethylen umfaßt, und daß die Dicke der isolierenden Folie höchstens gleich 50 μm ist.

2. Kapazitives Tastenfeld nach Anspruch 1, dadurch gekennzeichnet, daß die isolierende Folie von Vinylidenfluorid gebildet wird.

3. Kapazitives Tastenfeld nach Anspruch 1 oder 2, dadurch gekennzeichnet, daß die isolierende Folie durch Ziehen gebildet wird.

4. Kapazitives Tastenfeld nach Anspruch 1, 2 oder 3, dadurch gekennzeichnet, daß die isolierende Folie durch ein elektrisches Feld elektrisch polarisiert ist.

5. Kapazitives Tastenfeld nach einem der vorangehenden Ansprüche, dadurch gekennzeichnet, daß die Bereiche ($3_1$, $3_2$) auf der isolierenden Folie angebracht sind.

6. Kapazitives Tastenfeld nach Anspruch 5, dadurch gekennzeichnet, daß der leitende Anker (2) auf seiner Fläche, die zu den leitenden Bereichen weist, mit einer dünnen isolierenden Schicht (11) überzogen ist, die aus einem Material derselben Familie wie die isolierende Folie (4) besteht.

7. Kapazitives Tastenfeld nach Anspruch 1, dadurch gekennzeichnet, daß die Bereiche (3₁, 3₂) von wenigstens einer der beiden isolierenden Platten auf jener Fläche dieser Platte oder Platten getragen werden, die zu der isolierenden Folie (4) weist.

8. Kapazitives Tastenfeld nach Anspruch 7, dadurch gekennzeichnet, daß sich die isolierende Platte, die neben dem beweglichen Anker liegt, von einem Material der gleichen Familie wie die isolierende Folie (4) gebildet wird.

9. Kapazitives Tastenfeld nach einem der vorangehenden Ansprüche, dadurch gekennzeichnet, daß die verschiedenen Bauteile optische transparent sind.

## Claims

1. Capacitive keyboard of the matrix type, intended to provide a plurality of distinct orders when the various keys (1) of a keyboard are being depressed, and including a matricial arrangement of points (3) each being associated to a key of a keyboard, these points obeying the same repartition in rows and in columns than the keys, each of said points being itself composed of two conductive sections (3₁, 3₂) which are insulated from each other and which can be capacitively coupled one with the other one by the simple depressing of the associated key, this depressing of the key having the effect of bringing simultaneously close to these sections a same conductive piece (2) also associated to said key, the two sections (3₁, 3₂) being respectively placed against the two opposite sides of an insulating foil (4), in such positions that the projection of any one of said sections in the plane of the other section, along the direction perpendicular to this plane, is located next to this other section at a small distance from it, characterized in that said insulating foil (4) is made of one at least of the polymers and copolymes of a substance selected from the group consisting of the mono-, di- and trifluoroolefins of the ethylene family, the thickness of said insulating foil being at most equal to 50 microns.

2. Capacitive keyboard according to Claim 1, characterized in that the insulating foil is made of polyvinylidene fluoride.

3. Capacitive keyboard according to Claim 1 or 2, characterized in that the insulating foil has been formed by mechanically stretching.

4. Capacitive keyboard according to Claim 1, 2 or 3, characterized in that the insulating foil has been electrically poled in an electric field.

5. Capacitive keyboard according to any one of the preceding claims, characterized in that the sections (3₁, 3₂) are made on the insulating foil.

6. Capacitive keyboard according to Claim 5, characterized in that the conductive piece (2) is covered, on its side oriented towards the conductive sections, with a thin insulating layer (11) made of a material of the same family as that of the insulating foil (4).

7. Capacitive keyboard according to Claim 1, characterized in that the sections (3₁, 3₂) are carried by at least one of two insulating plates, on the side, of this or of these plates, oriented towards the insulating foil (4).

8. Capacitive keyboard according to Claim 7, characterized in that the insulating plate placed on the side of the conductive piece is made of a material of the same family as that of the insulating foil (4).

9. Capacitive keyboard according to any one of the preceding claims, characterized in that its constitutive parts are optically transparent.

# FIG.1.

# FIG.2.

# FIG.3.

# FIG.4.